# FASCICULE DE BREVET EUROPEEN

(11) **EP 2 184 741 B1**
(45) Date de publication et mention de la délivrance du brevet: **20.06.2012**
(21) Numéro de dépôt: 09013276.2
(22) Date de dépôt: 21.10.2009
(51) Int. Cl.: G11C 16/26, G11C 16/08, G11C 16/04

(54) **Mémoire EEPROM protégée contre les effets de claquage de transistors MOS**
EEPROM-Speicher, der gegen die Durchbrucheffekte von MOS-Transistoren geschützt ist
EEPROM memory protected against the effects of MOS transistor breakdown

(30) Priorité: 05.11.2008 FR 0806175
(43) Date de publication de la demande: 12.05.2010
(73) Titulaire: STMicroelectronics Rousset SAS, 13790 Rousset (FR)
(72) Inventeur: Tailliet, François, 13710 Fuveau (FR)
(74) Mandataire: Marchand, André

(56) Documents cités:
- EP-A- 0 292 658
- FR-A- 2 826 496
- MICHAEL L. BUSHNELL, VISHWANI D. AGRAWAL: "ESSENTIALS OF ELECTRONIC TESTING FOR DIGITAL, MEMORY AND MIXED-SIGNAL VLSI CIRCUITS" 31 décembre 2000 (2000-12-31), KLUWER ACADEMIC PUBLISHERS , BOSTON/DORDRECHT/LONDON 046212 , XP002520596 * page 262 - page 264 *

## Description

La présente invention concerne les mémoires effaçables et programmables électriquement.

La présente invention concerne plus particulièrement une mémoire effaçable et programmable électriquement, comprenant des cellules mémoire agencées en lignes de bit et en lignes de mot.

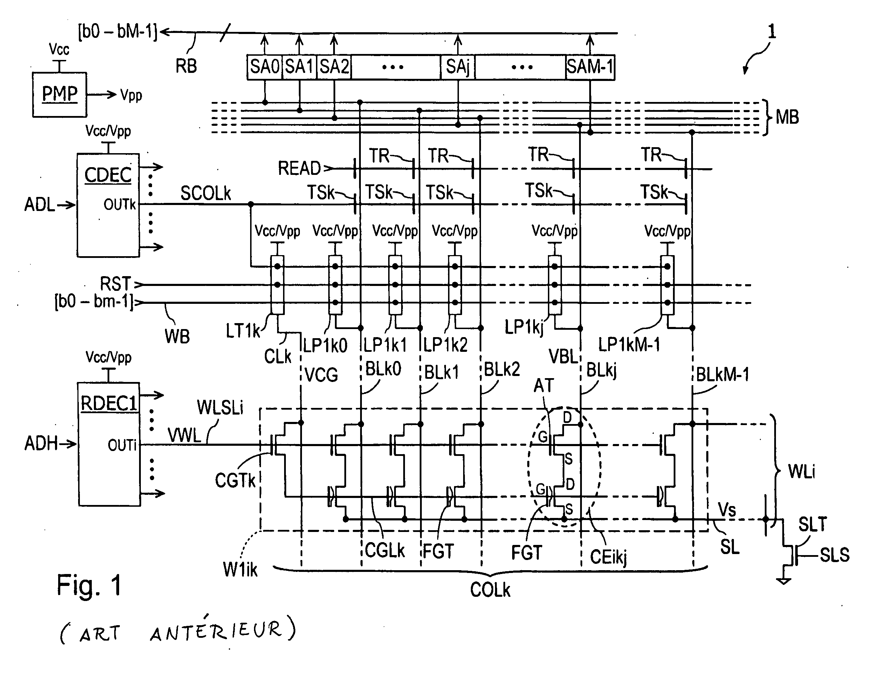

La figure 1 représente un exemple de mémoire EEPROM 1 du type précité. La mémoire comprend des cellules mémoire CEikj connectées à des lignes de sélection de ligne de mot WLSLi et à des lignes de bits BLkj transversales aux lignes de mot. Les lignes de bits sont groupées en colonnes COLk comprenant M lignes de bit BLk0,...BLkj...,BLkM-1. Les cellules mémoire connectées à une même ligne de sélection WLSLi forment une ligne de mot WLi. Les cellules mémoire d'une même ligne de mot WLi connectées aux M lignes de bit d'une colonne COLk forment un mot mémoire W1 ik permettant de stocker M bits. Dans un souci de simplicité, un seul mot W1 ik appartenant à une colonne COLk et à une ligne de mot WLi est représenté sur la figure 1.

Chaque cellule mémoire CEikj comprend un transistor à grille flottante FGT et un transistor d'accès AT de type MOS. Le transistor AT comprend une borne de grille G connectée à la ligne WLSLi, une borne de drain D connectée à une ligne de bit BLkj et une borne de source S connectée à une borne de drain D du transistor FGT. Le transistor FGT comprend une borne de grille de contrôle G connectée à une ligne de contrôle de grille CGLk et une borne de source S connectée à une ligne de source SL. La ligne SL est connectée à la masse par l'intermédiaire d'un transistor SLT piloté par un signal SLS. La ligne CGLk est reliée à une ligne de sélection de colonne CLk par l'intermédiaire d'un transistor de contrôle de grille CGTk ayant une borne de grille connectée à la ligne WLSLi.

Chaque ligne WLSLi est contrôlée par un signal VWL fourni par une sortie OUTi d'un décodeur de ligne RDEC1. Chaque ligne CLk est contrôlée par un signal de contrôle de grille VCG fourni par un verrou de colonne LT1k. Chaque verrou LT1k est contrôlé par un signal de sélection de colonne SCOLk fourni par une sortie OUTk d'un décodeur de colonne CDEC. Les décodeurs RDEC1 et CDEC reçoivent respectivement les bits de poids fort ADH et de poids faible ADL de l'adresse d'un mot W1 ik à sélectionner dans la mémoire 1.

Chaque ligne de bit BLkj est reliée à un verrou de ligne de bit LP1 kj piloté par le signal de sélection de colonne SCOLk. Chaque verrou LP1 kj est connecté à un bus WB pour recevoir, avant une opération de programmation, un bit de données bj parmi M bits b0 à bM-1 d'un mot de donnée à écrire. Chaque ligne de bit BLkj est également reliée à un amplificateur de lecture SAj par l'intermédiaire d'un transistor de sélection de colonne TSk, d'un transistor de lecture TR et d'un bus de multiplexage MB. Les transistors TSk sont pilotés par le signal de sélection de colonne SCOLk tandis que les transistors TR sont pilotés par un signal de lecture READ. Des amplificateurs de lecture SA0 à SAM-1, connectés en entrée au bus MB et en sortie à un bus RB, permettent de lire les M bits d'un mot W1 ik.

Dans une telle mémoire, une opération d'effacement ou de programmation de cellules mémoire consiste dans l'injection ou l'extraction de charges électriques par effet tunnel (effet Fowler Nordheim) dans la grille flottante des transistors FGT. Un transistor FGT présente à l'état programmé une tension de seuil VTw, et à l'état effacé, une tension de seuil VTe. Lorsqu'une tension de lecture Vread comprise entre VTw et VTe est appliquée sur sa grille de contrôle, un transistor FGT à l'état programmé est passant, ce qui correspond par convention à un "1" logique, et un transistor à l'état effacé est bloqué, ce qui correspond par convention à un "0" logique, une convention inverse pouvant être retenue.

L'effacement collectif des transistors FGT d'une ligne de mot WLi est réalisé en appliquant une tension Vpp de 15 à 20 V sur la grille de contrôle des transistors FGT, pendant que la ligne de source SL est à 0 et que les lignes de bit BLkj sont à un potentiel flottant. La programmation individuelle de transistors FGT est obtenue en appliquant la tension Vpp sur les drains des transistors FGT par l'intermédiaire des transistors d'accès AT, pendant que la grille de contrôle des transistors FGT est à 0 et que la ligne de source SL est à un potentiel flottant. Ces opérations sont réalisées au moyen des décodeurs RDEC1, CDEC, des verrous LT1 k et LP1 kj, en faisant monter la tension d'alimentation de ces éléments, de Vcc de l'ordre de 1,8 à 5,5 V, jusqu'à la tension Vpp. La tension Vpp est produite par une pompe de charge PMP à partir de la tension d'alimentation Vcc de la mémoire.

Le tableau 1 suivant résume les valeurs des signaux de contrôle pendant les opérations d'effacement, programmation et lecture d'une cellule mémoire CEikj. Dans le tableau 1, Vs est un signal de contrôle présent sur la ligne de source SL, VBL est un signal de contrôle présent sur la ligne de bit BLkj et Vsense est un signal fourni par les amplificateurs de lecture SAj.

**Tableau 1**

| Opération ⇒ | EFFACEMENT | PROGRAMMATION | LECTURE |
|---|---|---|---|
| Signaux de contrôle ⇓ | | | |
| VCG | Vpp | 0 (masse) | Vread |
| VWL | Vpp | Vpp | Vcc |
| Vs | 0 (masse) | Flottant | 0 (masse) |
| VBL | flottant | Vpp | Vsense |

En raison de l'application de la tension Vpp sur leur grille ou leur drain, plusieurs transistors subissent un stress électrique non négligeable au cours de cycles successifs d'effacement / programmation. Il s'agit notamment des transistors d'accès AT, des transistors à grille flottante FGT, de transistors dans les verrous de colonne LT1k et de bit line LP1 kj, et de transistors dans le décodeur de ligne RDEC1.

Les oxydes de grille de ces transistors sont choisis en conséquence, et sont réalisés pour supporter des tensions pouvant atteindre les 30 V. Toutefois, les oxydes de grille ne sont pas parfaits et présentent divers défauts ou impuretés susceptibles d'entraîner leur claquage dans des conditions normales d'utilisation. Ainsi, on observe parfois le claquage d'un transistor bien avant les centaines de milliers de cycles d'effacement /programmation spécifiés. Bien que la probabilité de claquage d'un transistor soit faible, le nombre de cellules mémoire présent dans une mémoire EEPROM est élevé et, statistiquement, le taux de défaillance d'une mémoire en raison d'un claquage d'oxyde de grille est l'une des causes essentielles, voire la cause essentielle de défaillance d'une mémoire EEPROM en utilisation.

Pour pallier cet inconvénient, il est connu, durant les tests de fabrication d'appliquer aux mémoires un stress électrique qui peut être supérieur à celui que subit une mémoire en usage normal. Ces opérations permettent d'éliminer les mémoires présentant des défauts de fabrication ou ayant une robustesse très insuffisante. Toutefois, ces opérations nécessitent plusieurs milliers de cycles de programmation pour tester tous les transistors et donc éliminer les mémoires présentant des défauts d'oxyde de grille. Ces opérations s'avèrent insuffisantes puisque les mémoires EEPROM sont généralement conçues pour supporter 1 million de cycles de programmation par octet, et que le taux de panne d'une telle mémoire en raison d'un claquage d'oxyde de grille atteint encore une proportion d'environ une mémoire sur 1 million (1 ppm).

Il a également été proposé d'associer aux bits de données stockés dans la mémoire un code de correction d'erreur, ou code ECC, permettant de détecter et corriger au moins un bit erroné dans une chaîne de bits. Par exemple, un code de Hamming de 4 bits ajouté à 8 bits de données permet de détecter et corriger un bit erroné au moment de la lecture de la chaîne de bits. Cette précaution s'avère généralement suffisante pour corriger les conséquences du claquage d'un transistor à grille flottante FGT, mais se révèle inefficace pour contrer une défaillance d'un transistor d'accès AT. En effet, il peut être impossible d'effacer correctement les cellules mémoire d'une ligne de mot WLi connectée à un transistor d'accès AT défectueux, ou de programmer correctement des cellules mémoire d'une ligne de bit BLkj connectée à un transistor d'accès défectueux.

Le brevet FR 2 826 496 (US 6 934 192) décrit des aménagements d'une mémoire EEPROM pour s'affranchir des effets de claquage d'un transistor d'accès pendant des phases d'effacement de cellules d'une ligne de mot connectée à un transistor d'accès défectueux, et pendant des phases de programmation de cellules de la ligne de bit connectée au transistor d'accès défectueux.

Le brevet FR 2 858 725 (US 7 239 192) décrit une pompe de charge associée à un circuit permettant de détecter une défaillance dans des étages de la pompe de charge, la pompe de charge comprenant un étage de remplacement prévu pour remplacer un étage endommagé. Il est également prévu d'associer à chaque mot mémoire un code de correction d'erreur permettant de corriger certains cas d'erreur de lecture de bit.

Le brevet EP-A-0292658 décrit une carte mémoire avec un circuit logique et de deux mémoires EEPROM en parallèle dont les valeurs sont comparées par un comparateur.

Toutefois, ces solutions ne permettent pas de s'affranchir des effets d'un claquage d'oxyde de grille de transistor dans une mémoire EEPROM, si le transistor défaillant se trouve dans un verrou de ligne de bit, de colonne ou dans le décodeur de ligne de mot. D'une manière plus générale, ces solutions ne permettent dans tous les cas précités, ni de détecter qu'un bit stocké dans la mémoire est erroné en raison d'un claquage d'oxyde de grille, ni de corriger la valeur d'un bit erroné. En effet, si le claquage d'un oxyde de grille concerne par exemple un transistor du décodeur de ligne, toutes les cellules mémoire d'une ligne de mot peuvent être défectueuses. Il en résulte que la prévision d'un code de correction d'erreur mémorisé dans des cellules mémoire de la même ligne de mot est inopérante.

Dans certains équipements comportant des mémoires EEPROM, comme ceux embarqués à bord de véhicules, il est nécessaire que le taux de panne soit très faible. Il est donc souhaitable de réduire le taux de panne des mémoires EEPROM résultant de claquages d'un oxyde de grille de transistor.

Ainsi, dans un mode de réalisation, il est prévu une mémoire effaçable et programmable électriquement, comprenant des cellules mémoire agencées en lignes de bit et en lignes de mot transversales aux lignes de bit, chaque cellule mémoire pouvant être dans un état programmé ou effacé. Selon un mode de réalisation, la mémoire comprend des circuits de sélection et d'accès de cellules mémoire configurés pour mémoriser et lire un bit de donnée dans deux cellules mémoire appartenant à des lignes de bit distinctes et des lignes de mot distinctes, et pour éviter qu'une cellule mémoire soit par erreur écrite ou lue dans un autre état qu'un état par défaut à la suite d'un claquage d'oxyde de grille d'un transistor de la mémoire, et un circuit de lecture pour déterminer un bit de donnée à lire dans la mémoire en fonction des états des deux cellules mémoire mémorisant le bit de donnée.

Selon un mode de réalisation, le circuit de lecture est configuré pour que l'état d'une cellule mémoire non erronée soit, pour le circuit de lecture, prépondérant sur l'état par défaut de cellule mémoire erronée.

Selon un mode de réalisation, les cellules mémoire sont regroupées en emplacements de mot qui peuvent chacun être sélectionnés par un décodeur de colonne de mot et un décodeur de ligne de mot, un mot de donnée étant mémorisé dans la mémoire en deux emplacements de mot appartenant à des lignes de mot distinctes et des colonnes de mot distinctes.

Selon un mode de réalisation, l'état par défaut de cellule mémoire erronée est l'état effacé, le circuit de lecture comprenant une porte logique OU fournissant un bit de donnée mémorisé en mémoire, en fonction des états des deux cellules mémoire mémorisant le bit de donnée.

Selon un mode de réalisation, l'état par défaut de cellule mémoire erronée est l'état effacé, chaque cellule mémoire comprenant un transistor à grille flottante et un transistor d'accès connecté à une borne du transistor à grille flottante, la mémoire comprenant des circuits pour générer une tension de lecture de cellules mémoire choisie plus proche d'une tension de seuil de transistor à grille flottante à l'état programmé qu'une tension de seuil de transistor à grille flottante à l'état effacé, de manière à privilégier l'état effacé lors de la lecture d'une cellule mémoire.

Selon un mode de réalisation, l'état par défaut est l'état programmé, le circuit de lecture comprenant une porte logique ET fournissant un bit mémorisé dans la mémoire en fonction des états des deux cellules mémoire mémorisant le bit de donnée.

Selon un mode de réalisation, la mémoire comprend des verrous de ligne de bit, des verrous de colonne et des verrous de ligne de mot pour commander l'effacement, la programmation et la lecture de cellules mémoire, qui sont configurés pour qu'une cellule mémoire sélectionnée soit lue dans l'état par défaut en cas de claquage d'un oxyde de grille de transistor.

Selon un mode de réalisation, chaque cellule mémoire comprend un transistor à grille flottante et un transistor d'accès connecté à une borne du transistor à grille flottante, la mémoire comprenant un circuit de sélection de ligne de mot pour appliquer un premier signal à la grille du transistor d'accès de cellules d'une ligne de mot sélectionnée, et un second signal à la grille d'un transistor de contrôle de grille d'un mot sélectionné, le second signal étant distinct du premier signal.

Selon un mode de réalisation, la mémoire comprend des verrous de ligne de bit, des verrous de colonne et des verrous de ligne de mot pour commander l'effacement, la programmation et la lecture de cellules mémoire, les verrous de colonne et les verrous de ligne de mot comprenant des circuits redondants pour pouvoir générer des signaux d'effacement ou de programmation permettant d'assurer l'effacement d'une cellule mémoire à effacer, et empêchant la programmation par erreur d'une cellule mémoire, en cas de claquage d'un oxyde de grille de transistor.

Dans un mode de réalisation, il est également prévu un procédé d'accès à un bit de donnée dans une mémoire effaçable et programmable électriquement, comprenant des cellules mémoire agencées en lignes de bit et en lignes de mot transversales aux lignes de bit, chaque cellule mémoire pouvant être dans un état programmé ou effacé. Selon un mode de réalisation, le procédé comprend des étapes de sélection de deux lignes de bit distinctes et deux lignes de mot distinctes pour sélectionner deux cellules mémoire, la lecture du bit de donnée comprenant des étapes consistant à lire l'état des deux cellules mémoire sélectionnées, et déterminer la valeur du bit de donnée en fonction des états des deux cellules mémoire sélectionnées, l'accès à une cellule mémoire étant effectué en évitant qu'une cellule mémoire soit par erreur écrite ou lue dans un autre état qu'un état par défaut à la suite d'un claquage d'oxyde de grille d'un transistor de la mémoire.

Selon un mode de réalisation, lors de la détermination de la valeur du bit de donnée, l'état d'une cellule mémoire non erronée est prépondérant sur l'état par défaut de cellule mémoire erronée.

Selon un mode de réalisation, les cellules mémoire sont regroupées en emplacements de mot qui peuvent chacun être sélectionnés par un décodeur de colonne de mot et un décodeur de ligne de mot, le procédé comportant des étapes de sélection de deux colonnes de mot distinctes et deux lignes de mot distinctes pour accéder à deux emplacements de mot distincts chacun mémorisant un même mot de donnée.

Selon un mode de réalisation, l'état par défaut de cellule mémoire erronée est l'état effacé, la détermination de la valeur du bit de donnée étant effectuée en appliquant une fonction logique OU aux états des deux cellules mémoire sélectionnées.

Selon un mode de réalisation, l'état par défaut de cellule mémoire erronée est l'état effacé, chaque cellule mémoire comprenant un transistor à grille flottante et un transistor d'accès connecté à une borne du transistor à grille flottante, le procédé comprenant des étapes de génération d'une tension de lecture de cellules mémoire choisie plus proche d'une tension de seuil du transistor à grille flottante à l'état programmé qu'une tension de seuil du transistor à grille flottante à l'état effacé, de manière à privilégier l'état effacé lors de la lecture d'une cellule mémoire.

Selon un mode de réalisation, l'état par défaut est l'état programmé, la détermination de la valeur du bit de donnée étant effectuée en appliquant une fonction logique ET aux états des deux cellules mémoire sélectionnées.

Selon un mode de réalisation, chaque cellule mémoire comprend un transistor à grille flottante et un transistor d'accès connecté à une borne du transistor à grille flottante, le procédé comprenant des étapes d'application d'un premier signal à la grille du transistor d'accès de cellules d'une ligne de mot sélectionnée, et d'application d'un second signal à la grille d'un transistor de contrôle de grille d'un mot sélectionné, le second signal étant distinct du premier signal.

Des exemples de réalisation de l'invention seront décrits dans ce qui suit, à titre non limitatif en relation avec les figures jointes parmi lesquelles :
- la figure 1 précédemment décrite représente un exemple d'architecture de mémoire EEPROM classique,
- la figure 2 représente schématiquement l'organisation d'un plan mémoire d'une mémoire EEPROM, selon un mode de réalisation,
- la figure 3 représente schématiquement l'organisation d'un plan mémoire d'une mémoire EEPROM, selon un autre mode de réalisation,
- la figure 4 représente un exemple d'architecture de mémoire EEPROM, selon un mode de réalisation,
- la figure 5 représente des courbes de répartition de tensions de seuils de transistors à grille flottante dans une mémoire, en fonction de leur état, vierge, programmé et effacé,
- la figure 6 est un schéma d'un circuit d'un verrou de ligne de bit, selon un mode de réalisation,
- les figures 7A à 7C sont des schémas de circuits d'un verrou de colonne, selon un mode de réalisation,
- les figures 8A à 8C sont des schémas de circuits du décodeur de ligne de mot, selon un mode de réalisation,
- la figure 9 est un schéma d'un circuit de contrôle de courant prévu dans la mémoire représentée sur la figure 4.

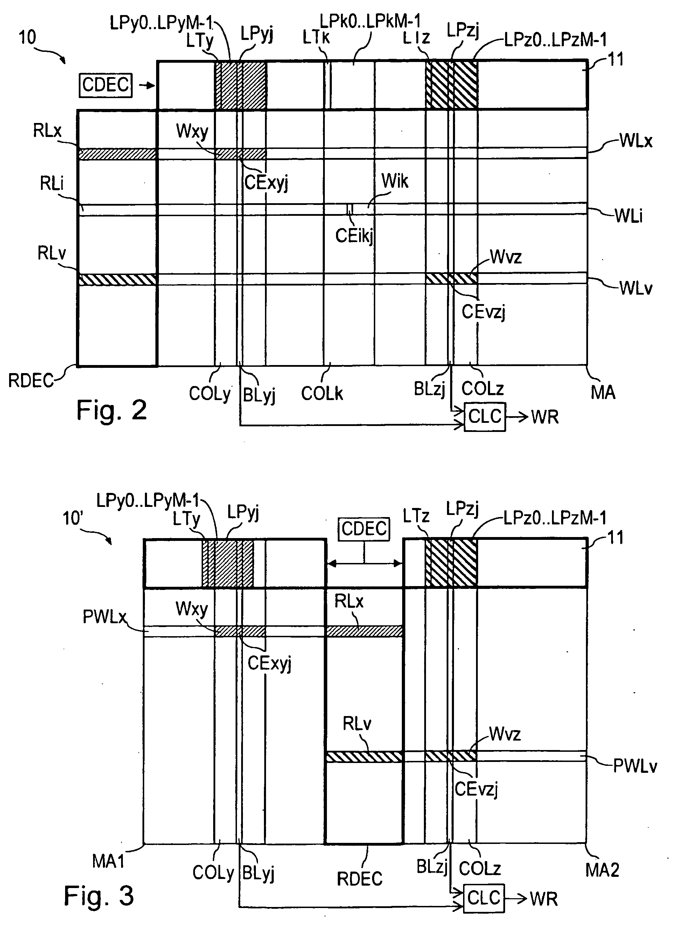

La figure 2 représente l'architecture d'une mémoire EEPROM 10 selon un mode de réalisation. La mémoire 10 comprend un plan mémoire MA dans lequel sont formées des cellules mémoire CEikj. Les cellules mémoire sont regroupées en mots Wik de M cellules mémoire, appartenant chacun à une colonne de mot COLk et une ligne de mot WLx transversale à la colonne de mot. La mémoire comprend un décodeur de ligne RDEC, un décodeur de colonne CDEC, et pour chaque colonne un verrou de colonne LTk et des verrous de ligne de bit LPk0..LPkM-1, commandés par le décodeur CDEC en fonction d'une adresse lecture ou d'écriture fournie à la mémoire. Les verrous LPkj permettent de commander sélectivement chaque cellule mémoire CEikj d'un mot Wik sélectionné. Le décodeur RDEC comprend des verrous de ligne de mot RLi qui sont commandés en fonction d'une adresse d'accès fournie à la mémoire.

Dans un mode de réalisation, le décodeur RDEC est configuré pour sélectionner et activer séquentiellement deux verrous de ligne de mot RLx, RLv afin de sélectionner deux lignes de mot WLx, WLv en fonction d'une adresse d'accès fournie à la mémoire 10. De même, le décodeur CDEC est configuré pour activer séquentiellement deux verrous de colonne LTy, LTz en fonction de l'adresse d'accès, afin de sélectionner deux colonnes COLy, COLz, et le cas échéant, activer des verrous de ligne de bit LPy0..LPyM-1, LPz0..LPzM-1 de chaque colonne sélectionnée, afin de sélectionner des cellules mémoire CExyj, CEvzj dans chaque mot sélectionné. Ainsi, un mot de donnée stocké dans la mémoire est mémorisé dans deux emplacements de mot mémoire Wxy, Wvz situés dans le plan mémoire MA dans deux lignes de mot distinctes WLx, WLv et deux colonnes distinctes COLy, COLz. Les opérations d'effacement, de programmation et de lecture de la mémoire sont donc effectuées en accédant séquentiellement à deux emplacements de mot mémoire dans le plan mémoire, sélectionnés en fonction d'une adresse d'accès à la mémoire. A cet effet, le décodeur de ligne RDEC et le décodeur de colonne CDEC sont configurés pour sélectionner deux lignes de mot et deux colonnes en fonction d'une adresse d'accès fournie à la mémoire. La valeur de chaque bit d'un mot de donnée lu dans la mémoire est obtenue par un circuit logique CLC combinant les états des deux cellules mémoire CExyj, CEvzj mémorisant le bit de donnée, dans les deux emplacements de mot mémoire Wxy, Wvz sélectionnés dans le plan mémoire MA.

Par ailleurs, la mémoire, et en particulier le plan mémoire MA, les verrous de colonne LTk, de ligne de bit LPk0..LPkM-1 et de ligne de mot RLi sont configurés pour éviter qu'une cellule mémoire soit par erreur écrite ou lue dans un autre état qu'un état par défaut à la suite d'un claquage d'oxyde de grille d'un transistor de la cellule ou d'un circuit de sélection ou d'accès de la mémoire. Autrement dit, la mémoire est configurée pour garantir qu'une commande d'écriture dans l'état par défaut de cellules mémoire soit toujours exécutée, et qu'une commande d'écriture dans un autre état que l'état par défaut ou une commande de lecture n'atteigne pas des cellules mémoire qui seraient sélectionnées par erreur.

Le circuit logique de combinaison CLC peut alors être configuré pour que l'état programmé ou effacé d'une cellule mémoire non défectueuse soit prépondérant sur l'état par défaut d'une cellule défectueuse. Ainsi, si l'état par défaut est l'état effacé, le circuit CLC peut être configuré pour déterminer la valeur d'un bit de donnée stocké dans la mémoire en appliquant une fonction logique OU à l'état de deux cellules mémoire mémorisant un même bit de donnée. Si l'état par défaut est l'état programmé, le circuit CLC peut être configuré pour déterminer la valeur d'un bit de donnée stocké dans la mémoire en appliquant une fonction logique ET à l'état de deux cellules mémoire mémorisant un même bit de donnée.

La figure 3 représente l'architecture d'une mémoire EEPROM 10' selon un autre mode de réalisation. La mémoire 10' diffère de la mémoire 10 en ce que les lignes de bits sont réparties en deux plans mémoire MA1, MA2, les lignes de mot étant divisées en deux parties appartenant chacune à l'un des plans mémoire MA1, MA2. Le décodeur de ligne RDEC est configuré pour activer simultanément en fonction d'une adresse fournie à la mémoire, seulement une partie de ligne de mot PWLx appartenant à un plan mémoire MA1, et une autre partie d'une autre ligne de mot PWLv appartenant à l'autre plan mémoire MA2. Le décodeur de colonne CDEC est configuré pour activer simultanément, en fonction de l'adresse fournie à la mémoire, une colonne de lignes de bit COLy appartenant à un plan mémoire MA1 et une colonne de lignes de bit COLz appartenant l'autre plan mémoire MA2. Deux emplacements de mot mémoire Wxy, Wvz sont ainsi sélectionnés simultanément en fonction d'une adresse fournie à la mémoire lors d'un accès en programmation, effacement ou lecture, les deux emplacements étant situés dans des plans mémoire distincts MA1, MA2 et dans deux lignes de mot distinctes WLx, WLv. Le circuit CLC peut alors recevoir simultanément les états des cellules mémoire des deux emplacements de mots lus et les combiner deux à deux pour déterminer la valeur d'un mot stocké en mémoire.

Il est à noter qu'il peut être prévu que la mémoire comporte un décodeur de ligne distinct par plan mémoire, lesquels sont activés simultanément pour accéder à deux emplacements de mot mémoire dans lesquels un même mot est stocké.

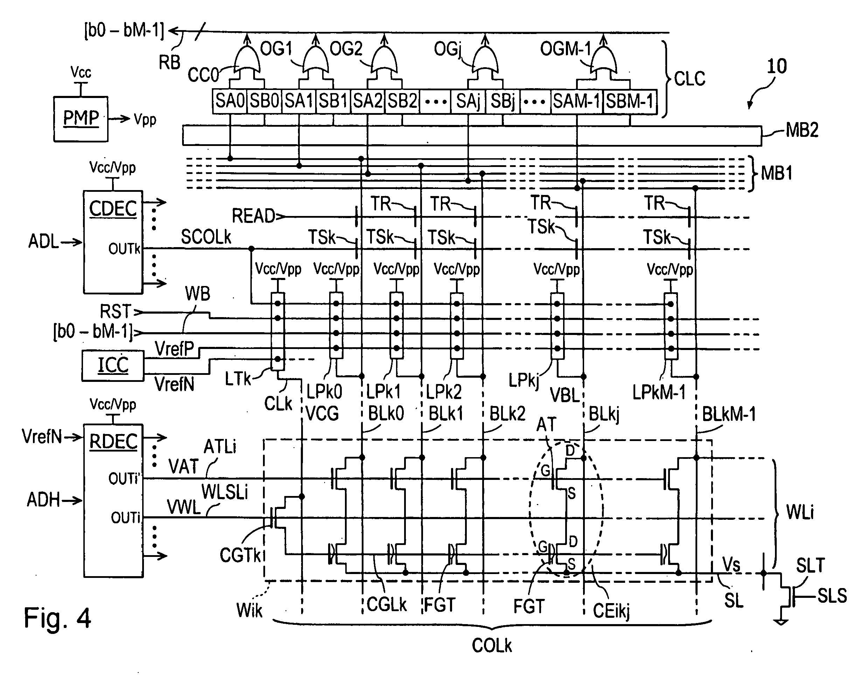

La figure 4 représente une mémoire EEPROM 10 selon un mode de réalisation. La mémoire comprend des cellules mémoire CEikj connectées à des lignes de sélection de ligne de mot WLSLi et à des lignes de bits BLj. Les lignes de bits sont groupées en colonnes COLk comprenant M lignes de bit BLk0,...BLkj...,BLkM-1. Les cellules mémoire connectées à une même ligne de sélection WLSLi forment une ligne de mot WLi. Les cellules mémoire d'une même ligne de mot WLi connectées aux M lignes de bit d'une colonne COLk forment un mot mémoire Wik de M cellules mémoire. Dans un souci de simplicité, un seul mot Wik appartenant à une colonne COLk et à une ligne de mot WLi est représenté sur la figure 4.

Chaque cellule mémoire CEikj comprend un transistor à grille flottante FGT et un transistor d'accès AT de type MOS. Le transistor AT comprend une borne de grille G, une borne de drain D connectée à une ligne de bit BLkj et une borne de source S connectée au drain D du transistor FGT. Le transistor FGT comprend une borne de grille de contrôle G connectée à une ligne de contrôle de grille CGLk et une borne de source S connectée à une ligne de source SL. La ligne SL est connectée à la masse par l'intermédiaire d'un transistor SLT piloté par un signal SLS. La ligne CGLk est reliée à une ligne de sélection de colonne CLk par l'intermédiaire d'un transistor de contrôle de grille CGTk ayant une borne de grille connectée à la ligne WLSLi.

Chaque ligne CLk est contrôlée par un signal de contrôle de grille VCG fourni par un verrou de colonne LTk. Chaque verrou LTk est contrôlé par un signal de sélection de colonne SCOLk fourni par une sortie OUTk du décodeur de colonne CDEC. Les décodeurs RDEC et CDEC reçoivent respectivement les bits de poids fort ADH et de poids faible ADL de l'adresse d'un mot Wik à sélectionner dans la mémoire.

Chaque ligne de bit BLkj est reliée à un verrou de programmation LPkj piloté par un signal de sélection de colonne SCOLk. Chaque verrou LPkj est connecté à un bus WB pour recevoir, avant une opération de programmation, un bit de données bj parmi M bits b0 à bM-1 d'un mot à écrire dans la mémoire. Chaque ligne de bit BLkj est également reliée à un amplificateur de lecture SAj par l'intermédiaire d'un transistor de sélection de colonne TSk, d'un transistor de lecture TR et d'un bus de multiplexage MB1. Les transistors TSk sont pilotés par le signal de sélection de colonne SCOLk, tandis que les transistors TR sont pilotés par un signal de lecture READ. Des amplificateurs de lecture SA0 à SAM-1, connectés en entrée au bus MB1 et reliés en sortie à un bus RB, permettent de lire les M bits d'un mot Wik. Les verrous LTk et LPkj reçoivent également un signal de remise à zéro RST.

Selon un mode de réalisation, la mémoire 10 comprend un second ensemble d'amplificateurs de lecture SB0 à SBM-1 pour lire un second mot dans la mémoire. Les amplificateurs SB0..SBM-1 sont connectés en entrée à un second bus MB2, et en sortie à une entrée d'un circuit logique respectif OG0..OGM-1 dont la sortie est connectée au bus RB. Une autre entrée de chacun des circuits OGj est connectée à un amplificateur SAj respectif. Le bus MB2 est également relié aux lignes de bit BLkj par l'intermédiaire de transistors de lecture TR pilotés par le signal READ et de transistors de sélection de colonne pilotés par un signal de sélection de colonne fourni par le décodeur CDEC. Lorsqu'une adresse ADL lui est fournie, le décodeur CDEC active deux signaux SCOLk pour sélectionner deux colonnes. Dans le mode de réalisation représenté sur la figure 4, l'état de cellule mémoire privilégié par défaut est l'état effacé. Les circuits logiques OGj sont donc des portes logiques OU. Si au moins l'une de deux cellules mémoire lues, connectées à une même porte OGj est à l'état programmé (à 1), cela signifie que cette cellule mémoire n'est pas défectueuse et donc que le bit de donnée lu est à 1. Si les deux cellules mémoire lues, connectées à une même porte OGj sont à l'état effacé (à 0), aucune, une ou les deux cellules mémoire peuvent être défectueuses. Si aucun ou une seule des deux cellules mémoire est défectueuse, la valeur du bit fournie par la porte OGj est correctement évaluée à 0. Si les deux cellules mémoire sont défectueuses, ce qui peut se produire avec une très faible probabilité, la valeur du bit fournie par la porte OGj est erronée.

Selon un mode de réalisation, la grille du transistor d'accès AT de chaque cellule mémoire CEikj n'est pas connectée à une ligne de sélection de ligne de mot WLSLi comme dans l'exemple de la figure 1, mais à une ligne spéciale ATLi, prévue pour le contrôle des grilles des transistors d'accès AT de la ligne de mot WLi à laquelle appartient la cellule. La ligne de sélection WLSLi de chaque ligne de mot WLi n'est connectée qu'au transistor de contrôle de grille CGTk du mot Wik, ainsi qu'aux transistors de contrôle de grille des autres mots appartenant à la ligne de mot WLi (non représentés).

Chaque ligne de sélection WLSLi est connectée à une sortie OUTi du décodeur de ligne RDEC fournissant de façon classique un signal VWL de sélection de ligne de mot. Le décodeur RDEC comprend pour chaque ligne WLi une deuxième sortie OUTi' qui est connectée à la ligne ATLi et qui fournit un signal VAT assurant le contrôle de la grille des transistors d'accès AT appartenant à la ligne WLi. Le signal VAT est identique au signal VWL pendant des phases de programmation ou de lecture, et la mémoire 10 fonctionne ainsi de façon classique en programmation et lecture. Par contre, pendant des phases d'effacement, le signal VAT est porté à une tension égale à celle du signal VS se trouvant sur la source des transistors à grille flottante FGT, soit ici une tension nulle.

De cette manière, si un transistor d'accès AT d'une cellule CEikj est défectueux, les autres cellules du même mot Wik peuvent être effacées.

Le tableau 2 ci-après résume les valeurs des signaux de contrôle pendant les opérations d'effacement, de programmation et de lecture de la mémoire 10. Comme précédemment, le signal de contrôle présent sur la ligne de bit BLkj est désigné VBL. La tension Vcc d'alimentation de la mémoire est de l'ordre de 1,8 à 5,5 V, la tension Vpp de l'ordre de 15 à 20V, la tension fournie par les amplificateurs de lecture SAj, SBj est désignée Vsense. Vread désigne la tension de lecture qui est appliquée la grille de contrôle du transistor FGT des cellules mémoire à lire. La tension Vread est comprise entre les tensions de seuil à l'état programmé VTw et à l'état effacé VTe.

**Tableau 2**

| Opération ⇒ | EFFACEMENT | PROGRAMMATION | LECTURE |
|---|---|---|---|
| Signaux de contrôle ⇓ | | | |
| VCG | Vpp | 0 (masse) | Vread |
| VWL | Vpp | Vpp (ou Vcc) | Vcc |
| VAT | 0 (masse) | Vpp | Vcc |
| Vs | 0 (masse) | Flottant | 0 (masse) |
| VBL | flottant | Vpp | Vsense |

En phase d'effacement d'une cellule mémoire, la grille et le canal du transistor d'accès AT de la cellule mémoire sont à une tension nulle. En phase de programmation, la grille du transistor VAT reçoit le signal VAT à la tension Vpp et son drain reçoit le signal VBL à une tension égale à Vpp - Vt, Vt étant une tension de seuil d'un transistor de type MOSN du verrou LPkj correspondant. Le claquage de l'oxyde de grille du transistor VAT aurait donc pour effet de mettre le signal VBL à la tension Vpp. Il n'en résulte donc aucun court-circuit entre la tension Vpp et la masse, ni de surconsommation. La défaillance éventuelle d'un transistor d'accès reste confinée à la cellule mémoire comportant le transistor d'accès défectueux, sans contamination aux autres cellules de la ligne de mot, en termes d'effaçabilité de ces cellules. En lecture d'une cellule mémoire, le claquage de l'oxyde de grille du transistor d'accès AT de la cellule mémoire entraîne un court-circuit entre sa grille et son canal, ce qui tend à porter le potentiel de la ligne de bit au potentiel du signal VAT. Il en résulte que l'amplificateur de lecture connecté à la ligne de bit va considérer que la cellule mémoire est à l'état effacé, quel que soit l'état réel de la cellule mémoire.

En phase de programmation, la structure de ligne de mot permet d'appliquer indifféremment la tension Vpp ou la tension Vcc sur la ligne de sélection de ligne de mot WLSLi (signal VWL), car le transistor de contrôle de grille CGTk doit seulement connecter à la masse la grille de contrôle des transistors FGT (signal VCG = 0). La tension du signal VWL peut donc être choisie différente de celle du signal VAT en phase de programmation. L'avantage de commander des transistors de contrôle de grille CGT avec la tension Vcc en phase de programmation, est de limiter le stress électrique subi par ces transistors.

Bien que l'on ait proposé dans ce qui précède l'application d'une tension nulle sur les grilles des transistors d'accès AT pendant les phases d'effacement, il va de soi que le signal VAT pourrait être porté à un potentiel flottant, ou à une autre valeur si la tension VS appliquée sur la source des transistors à grille flottante était différente de 0. Par exemple, certains procédés d'effacement font intervenir une tension de source négative. Le signal VAT serait dans ce cas à une tension négative pendant les phases d'effacement.

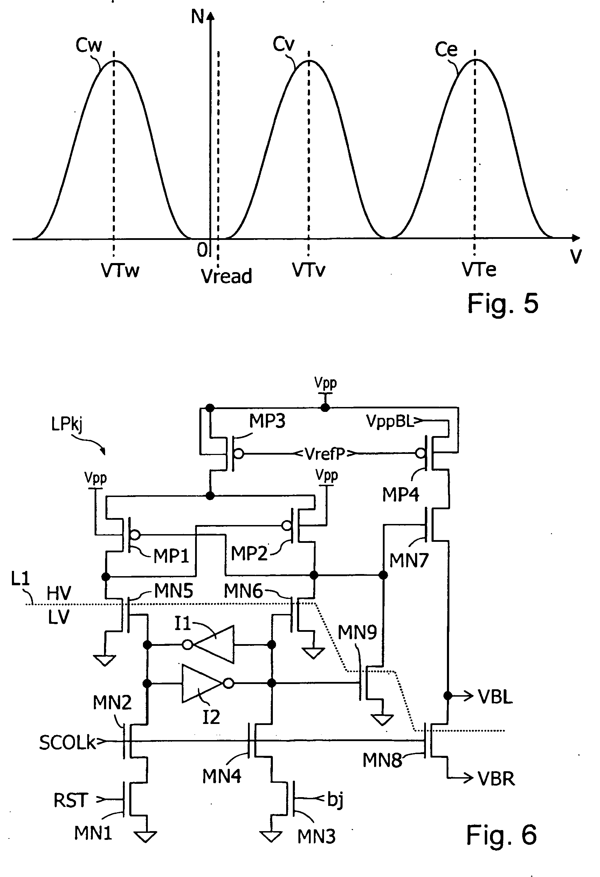

Selon un mode de réalisation, la tension de lecture Vread fournie par le verrou de colonne LTk d'un mot à lire est choisie de manière à privilégier l'état effacé des cellules mémoire. La figure 5 représente sous la forme de courbes d'histogramme Cw, Cv, Ce, la répartition en fonction du nombre de transistors, des tensions de seuils des transistors à grille flottante FGT d'une mémoire EEPROM, respectivement à l'état programmé, à l'état vierge et à l'état effacé. Les courbes Cw, Cv et Ce présentent la forme de courbes de Gauss centrées sur les tensions de seuil moyenne d'un transistor à grille flottante FGT, respectivement à l'état programmé VTw, à l'état vierge VTv et à l'état effacé VTe. Classiquement, la tension Vread est choisie sensiblement égale à la moyenne des tensions de seuil VTw et VTe, c'est-à-dire sensiblement centrée sur la tension de seuil à l'état vierge VTv. Pour privilégier l'état effacé, la tension de lecture Vread est choisie plus proche de la tension de seuil VTw que de la tension de seuil VTe. Typiquement, les tensions de seuil VTw, VTv et VTe sont respectivement voisines de -1 V, 1 V et 3 V. La tension Vread est choisie classiquement proche de la tension de seuil VTv pour garantir une meilleure rétention des données et parce que la tension VTv correspond sensiblement à la valeur moyenne des tensions de seuil VTw et VTe. Pour privilégier l'état effacé, la tension Vread est choisie dans une zone intermédiaire entre les courbes Cw et Cv où celles-ci présentent des valeurs voisines de 0. Ainsi, la tension Vread peut être choisie voisine de 0 V. De cette manière, une cellule vierge est toujours lue comme effacée. Par ailleurs, si un transistor à grille flottante FGT d'une cellule mémoire est défectueux, le résultat de la lecture peut être forcé à l'état effacé.

Bien entendu, il peut être prévu de choisir que l'état programmé soit l'état par défaut de lecture d'une cellule mémoire défectueuse, et de privilégier l'état programmé en lecture. Dans ce cas, la tension de lecture Vread est choisie plus proche de la tension de seuil VTe d'un transistor FGT à l'état effacé.

Selon un mode de réalisation, chaque verrou de ligne de bit LPkj, chaque verrou de colonne LTk et le décodeur RDEC sont asservis en courant par un circuit de contrôle de courant ICC, afin de ne fournir dans une ligne de bit BLkj, une ligne CLk, une ligne VAT et une ligne VWL un courant ne pouvant pas dépasser une valeur maximale. Cette valeur de courant maximum est calculée de manière que la somme des courants fournis n'excède pas le courant maximal pouvant être délivré par la source de tension Vpp, à savoir la pompe de charge PMP.

La figure 6 représente un circuit de verrou de ligne de bit LPkj. Le verrou LPkj comprend classiquement deux transistors PMOS MP1, MP2 recevant sur leur source la tension Vpp. La grille du transistor MP1 est connectée au drain du transistor MP2 et réciproquement, la grille du transistor MP2 est connectée au drain du transistor MP1. Le drain du transistor MP1 est également connecté au drain d'un transistor NMOS MN5, et la source du transistor MP2 est connectée au drain d'un transistor NMOS MN6. Les sources des transistors MN5 et MN6 sont connectées à la masse. Les grilles des transistors MN5 et MN6 sont connectées à deux portes inverseuses 11, 12 montées tête-bêche formant un verrou. La grille du transistor MN5 est également connectée au drain d'un transistor NMOS MN2 connecté en série avec un transistor NMOS MN1 dont la source est connectée à la masse. La grille du transistor MN2 reçoit le signal SCOLk, et la grille du transistor MN1 reçoit le signal RST. La grille du transistor MN6 est également connectée au drain d'un transistor NMOS MN4 connecté en série avec un transistor NMOS MN3 dont la source est connectée à la masse. La grille du transistor MN4 reçoit le signal SCOLk et la grille du transistor MN3 reçoit l'une des données bj d'un mot à écrire. Chaque verrou LPkj comprend également un transistor NMOS MN7 recevant sur son drain un signal VppBL et dont la grille est connecté aux drains des transistors MP2 et MN6. La source du transistor MN7 est connectée au drain d'un transistor NMOS MN8, et fournit le signal VBL à la ligne de bit correspondante BLkj. La grille du transistor MN8 reçoit le signal SCOLk et la source de ce transistor fournit un signal VBR qui est envoyé sur l'un des bus MB1 ou MB2. Le signal VppBL est à 0 lors d'une opération d'effacement de cellules de la mémoire et à la tension Vpp durant une opération d'écriture.

Une ligne L1 représentée en pointillés sur la figure 6 délimite une zone du circuit susceptible d'être soumise à une haute tension HV voisine de la tension Vpp, et une zone soumise à une tension plus basse LV, située en dessous de cette ligne. Les transistors MP1 à MP4 et MN7, et le drain des transistors MN5, MN6 et MN8 sont situés dans la zone soumise à la haute tension. Les transistors exposés au risque de claquage d'oxyde de grille sont ceux dont les bornes peuvent être soumises à des différences de potentiel élevées. Les transistors MP3 et MP4 ne subissent qu'un écart de tension entre leurs bornes de l'ordre de la tension de seuil d'un transistor MOS. Les transistors MP1 et MP2 peuvent avoir leurs grilles ou leurs drains à 0 V, et le transistor MN7 peut également avoir sa grille à 0 V. Il en résulte que seuls les transistors MP1, MP2, MN5, MN6, MN7 et MN8 sont exposés à un risque de claquage de leur oxyde de grille.

Selon un mode de réalisation, chaque verrou de ligne de bit LPkj comprend un transistor PMOS MP3 qui transmet la tension Vpp à la source des transistors MP1 et MP2, et un transistor PMOS MP4 qui transmet le signal VppBL au drain du transistor MN7, les substrats des transistors MP1, MP2, MP3 et MP4 étant à la tension Vpp. Les grilles des transistors MP3 et MP4 reçoivent une tension de référence VrefP. La tension VrefP est choisie de manière à limiter le courant maximal traversant les transistors MP1 et MP2 à une valeur de l'ordre de 1 µA. A cet effet, la tension VrefP est choisie telle que la tension (Vpp - VrefP) soit très légèrement supérieure en valeur absolue à la tension de seuil des transistors MP1 et MP2. Chaque verrou de ligne de bit LPkj comprend un transistor NMOS MN9 dont le drain est connecté à la grille du transistor MN7 et aux drains des transistors MP2 et MN6, dont la grille est connectée au drain du transistor MN4, et dont la source est à la masse. Les transistors MP3 et MP4 et le drain du transistor MN9 se trouvent dans la zone soumise à une haute tension (au-dessus de la ligne L1 sur la figure 6).

Chaque verrou LPkj comprend ainsi un verrou basse tension formé des deux portes inverseuses I1, I2 et un circuit de translation de niveau (lever shifter) formé des transistors MP1, MP2, MN5 et MN6. Si le verrou basse tension est levé durant une phase de programmation, le signal VBL est à la tension de programmation, soit Vpp. Si le verrou est baissé, le signal VBL est à un potentiel flottant.

Les transistors MP3 et MP4 sont polarisés pour assurer une fonction de limitation de courant. Ils permettent ainsi d'empêcher une chute des tensions Vpp et VppBL en cas de défaillance du transistor MP1 ou MP2 ou d'une défaillance du transistor MN7, empêchant ainsi une baisse de la valeur absolue de la tension de seuil VTw ou VTe. Typiquement, l'intensité des signaux fournis par les transistors MP3 et MP4, et donc l'intensité du signal VBL est limitée à une valeur de l'ordre de 1 µA.

Le circuit de verrou LPkj qui vient d'être décrit permet de garantir qu'une commande d'effacement d'une cellule mémoire soit exécutée même si un ou plusieurs des transistors MP1, MP2, MN5, MN6, MN7 et MN8 a subi un claquage d'oxyde de grille, l'état par défaut choisi de cellule mémoire étant l'état effacé. A cet effet, le verrou LPkj ne peut pas être levé s'il était à l'état abaissé. En effet, pour que le verrou apparaisse à l'état levé alors qu'il était à l'état abaissé, il faudrait que le potentiel de grille du transistor MN7 monte à la tension Vcc. Pour cela, il faudrait qu'un courant passe dans le transistor MP3, lequel est limité à 1 µA. Or lorsque le verrou est à l'état abaissé, la sortie de la porte I2 est nécessairement à la tension Vcc. Par conséquent, le transistor MN9 est à l'état passant et tire vers la masse la grille du transistor MN7. Un claquage de transistor pourrait se traduire par un conflit entre le transistor MN9 et le courant de 1 µA fourni par le transistor MP3. Si le transistor MN9 est dimensionné pour fournir un courant bien supérieur à 1 µA, il force à 0 la tension de grille du transistor MN7 en cas de claquage.

Par ailleurs, un claquage du transistor MN7 devenant passant ne risque pas de faire monter la tension du signal VBL. En effet, pour que la tension du signal VBL monte, il faudrait que la grille du transistor MN7 soit en court circuit avec son drain. Si tel est le cas, le potentiel de grille du transistor MN7 monte en tendant vers la tension Vpp par un courant limité à 1 µA par le transistor MP4. Si le verrou est à l'état abaissé, le transistor MN9 tire fortement la grille du transistor MN7 vers un potentiel nul et donc impose sa tension à l'encontre d'un éventuel tirage accidentel du potentiel de la grille du transistor MP4 vers la tension Vpp. Il en résulte que la défaillance d'un verrou LPkj n'a d'effet qu'en phase de programmation où il peut empêcher la programmation d'une cellule mémoire qui reste donc dans l'état effacé.

Le circuit de verrou LPkj qui vient d'être décrit permet également d'assurer qu'en cas de claquage d'un oxyde de grille d'un ou plusieurs de ses transistors, il consomme un courant maximum limité à une valeur faible inférieure à 2 µA. En effet, cette condition est vérifiée car les deux branches du circuit recevant la tension Vpp sont limitées à un courant de 1 µA par le transistor MP3 ou MP4. Dans le pire des cas, correspondant à un claquage de transistor dans les deux branches, le courant maximal consommé est limité à 2 µA.

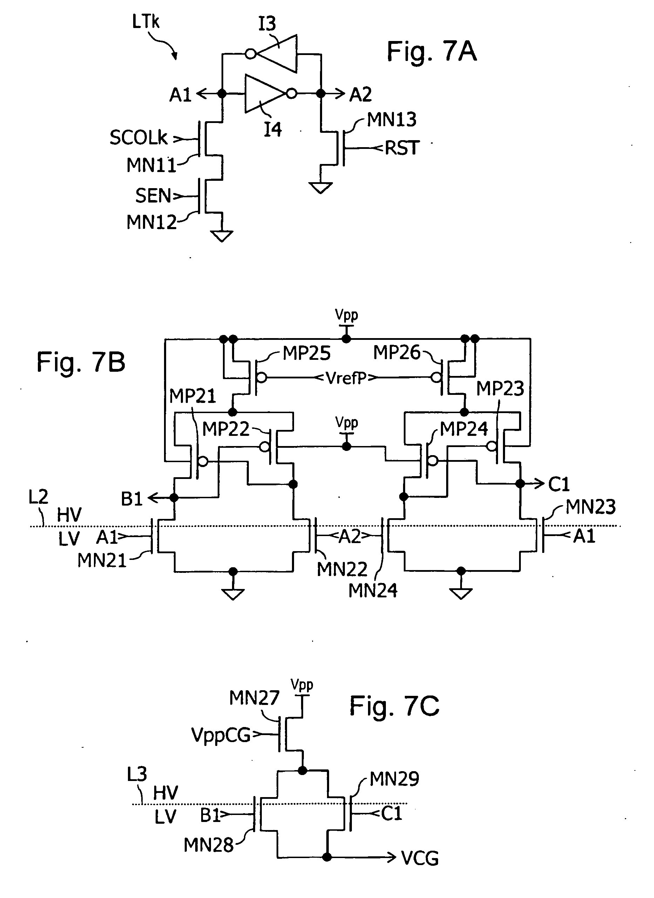

Les figures 7A à 7C représentent des circuits d'un verrou de colonne LTk. Sur la figure 7A, chaque verrou LTk comprend deux portes inverseuses I3, I4 montées tête-bêche, formant un verrou basse tension. Les bornes des portes inverseuses I3, I4 fournissent des signaux A1 et A2. Le signal A1 est fourni au drain d'un transistor NMOS MN11 connecté en série à un transistor NMOS MN12 dont la source est à la masse. La grille du transistor MN11 reçoit le signal SCOLk, et la grille du transistor MN12 reçoit un signal de validation de décodage SEN. Le signal A2 est appliqué au drain d'un transistor NMOS MN13 dont la grille reçoit le signal RST et dont la source est à la masse.

Sur la figure 7B, chaque verrou de ligne LTk comprend six transistors PMOS MP21, MP22, MP23, MP24, MP25 et MP26, et quatre transistors NMOS MN21, MN22, MN23 et MN24. La source des transistors MP25 et MP26, ainsi que le substrat des transistors MP21 à MP26 reçoivent la tension Vpp. Les grilles des transistors MP25 et MP26 reçoivent la tension de référence VrefP. Les sources des transistors MP21 et MP22 sont connectées au drain du transistor MP25. Les sources des transistors MP23 et MP24 sont connectées au drain du transistor MP26. La grille du transistor MP21 est connectée au drain du transistor MP22, et réciproquement, la grille du transistor MP22 est connectée au drain du transistor MP21. De même, la grille du transistor MP23 est connectée au drain du transistor MP24, et réciproquement, la grille du transistor MP24 est connectée au drain du transistor MP23.

Le drain du transistor MP21 qui fournit un signal B1, est connecté au drain du transistor MN21 dont la grille reçoit le signal A1 et dont la source est connectée à la masse. Le drain du transistor MP22 est connecté au drain du transistor MN22 dont la grille reçoit le signal A2 et dont la source est connectée à la masse. De même, le drain du transistor MP23 qui fournit un signal C1, est connecté au drain du transistor MN23 dont la grille reçoit le signal A1 et dont la source est connectée à la masse. Le drain du transistor MP24 est connecté au drain du transistor MN24 dont la grille reçoit le signal A2 et dont la source est connectée à la masse.

La valeur de la tension VrefP choisie permet également de limiter le courant maximal traversant les transistors MP21 à MP24 à une valeur de l'ordre de 1 µA.

Sur la figure 7C, chaque verrou LTk comprend trois transistors NMOS MN27, MN28 et MN29. Le drain du transistor MN27 reçoit la tension Vpp, et la grille de ce transistor reçoit un signal VppCG. La source du transistor MN27 est connectée aux drains des transistors MN28 et MN29 dont les sources fournissent le signal VCG. La grille du transistor MN28 reçoit le signal B1 et la grille du transistor MN29 reçoit le signal C1. Le signal VppCG est à la tension Vpp durant les phases d'effacement de cellules mémoire et à 0 (à la masse) durant les phases de programmation de cellules mémoire.

Les figures 7B et 7C montrent en pointillés une ligne L2, L3 de séparation entre des zones de circuit susceptibles d'être soumises à une haute tension HV de l'ordre de la tension Vpp, et des zones soumises à une tension plus basse LV, l'ensemble du circuit de la figure 7A n'étant pas susceptible d'être soumis à la haute tension HV. Les lignes L2 et L3 font apparaître que seuls les transistors MP21 à MP26 et MN27, ainsi que les drains des transistors MN21 à MN24, MN28 et MN29 sont susceptibles d'être soumis à la haute tension HV. Pour des raisons analogues à celles exposées ci-dessus en référence à la figure 6, seuls les transistors MP21 à MP24, MN21 à MN24, MN28 et MN29 sont exposés à un risque de claquage d'oxyde de grille.

Si le verrou basse tension formé par les deux inverseurs 13, 14 est levé (à 1), le signal VCG en sortie du verrou RLi est à la tension Vpp durant une phase d'effacement des cellules mémoire correspondantes. En revanche, si le verrou est abaissé (à 0), le signal VCG est placé à un potentiel flottant. Les transistors MP25 et MP26 sont polarisés pour assurer une fonction de limitation de courant. Ils permettent ainsi d'empêcher une chute des tensions Vpp et VppCG en cas de défaillance d'un des transistors MP21 à MP24 ou d'un des transistors MN21 à MN24, empêchant ainsi une baisse de la valeur absolue de la tension de seuil VTw ou VTe. Typiquement, l'intensité des signaux fournis par les transistors MP25 et MP26, et donc l'intensité des signaux B1 et C1 est limitée à une valeur de l'ordre de 1 µA.

Par ailleurs, le circuit de la figure 7B comprend deux circuits redondants de translation de niveau de tension fournissant respectivement les signaux B1 et C1 en entrée du circuit de la figure 7C. Ainsi, si l'un des deux circuits de translation de niveau de tension est défaillant en raison de la défaillance d'un des transistors MP21, MP22, MN21, MN22 du premier circuit, ou l'un des transistors MP23, MP24, MN23, MN24 du second circuit, l'un des signaux B1 ou C1 est toujours présent. Le circuit de la figure 7C assure la fonction d'une porte logique OU recevant en entrée les signaux B1 et C1 et fournissant en sortie le signal VCG.

De cette manière, le verrou de LTk qui vient d'être décrit permet également de garantir qu'une commande d'effacement de cellules mémoire soit exécutée même si l'un des transistors haute tension du verrou a subi un claquage d'oxyde de grille, l'état par défaut choisi de cellule mémoire étant l'état effacé. A cet effet, le verrou de LTk assure que les conditions suivantes sont réalisées en cas de défaillance d'un transistor haute tension. Si le verrou I1, I2 est abaissé, il peut rester abaissé ou être levé à cause du transistor défaillant. S'il est levé, il ne doit pas passer par erreur à l'état non levé. En effet, les signaux B1 et C1 fournis par les deux circuits de translation de niveau redondants (figure 7B) sont identiques en l'absence de claquage d'un transistor haute tension. Le positionnement du verrou correspond à l'un des signaux B1 et C1 mis à la tension Vpp. En cas de claquage d'un transistor dans l'un des deux circuits de translation de niveau, l'un des signaux B1 ou C1 n'est plus valide, c'est-à-dire que l'un de ces signaux reste à la tension Vpp et l'autre se trouve dans un état indéterminé. Grâce à la fonction logique OU réalisée par le circuit de la figure 7C, le signal VCG pourra toujours passer à la tension Vpp pour réaliser un effacement de cellules mémoire. Il en résulte que la défaillance d'un verrou LTk n'a d'effet qu'en phase de programmation où il peut empêcher la programmation d'une cellule mémoire.

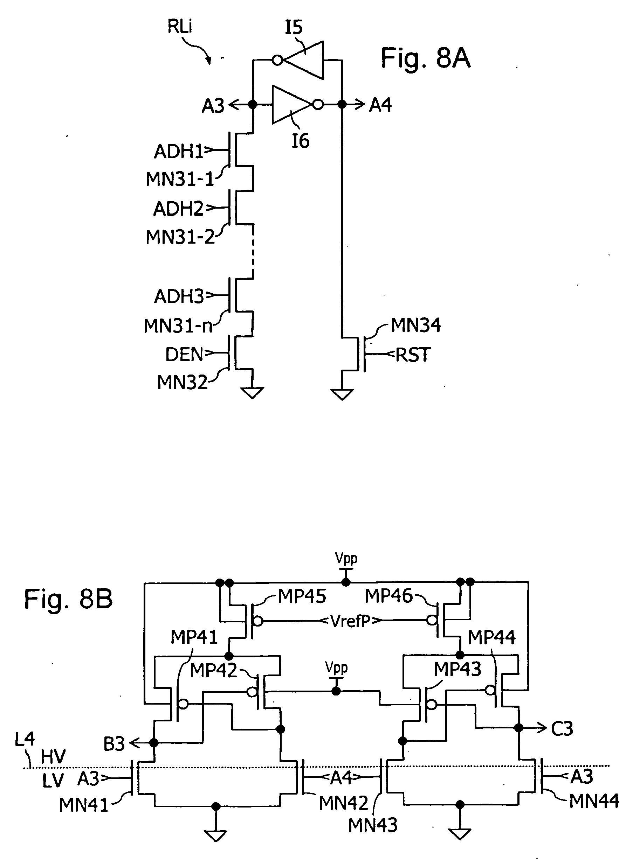

Les figures 8A à 8C représentent des circuits d'un verrou de ligne de mot RLi. Sur la figure 8A, chaque verrou RLi comprend deux portes inverseuses I5, I6 montées tête-bêche, formant un verrou basse tension. Les bornes des portes I5, I6 fournissent des signaux A3 et A4. Le signal A3 est appliqué à une branche comprenant plusieurs transistors NMOS MN31-1, MN31-2, ... MN31-n et MN32 en série, la source du transistor MN32 étant connectée à la masse. Les grilles des transistors MN31-1 à MN31-n reçoivent un signal de bit d'adresse respectif ADH1, ADH2, ADH3, ..., et la grille du transistor MN32 reçoit un signal de validation de décodage DEN. Le signal A4 est appliqué au drain d'un transistor NMOS MN34 dont la grille reçoit le signal RST et dont la source est à la masse.

Sur la figure 8B, chaque verrou RLi comprend six transistors PMOS MP41, MP42, MP43, MP44, MP45 et MP46 et quatre transistors NMOS MN41, MN42, MN43 et MN44. La source des transistors MP45 et MP46, ainsi que les substrats des transistors MP41 à MP46 reçoivent la tension Vpp. Les grilles des transistors MP45 et MP46 reçoivent la tension de référence VrefP. La source des transistors MP41 et MP42 sont connectées au drain du transistor MP45. La source des transistors MP43 et MP44 sont connectées au drain du transistor MP46. La grille du transistor MP41 est connectée au drain du transistor MP42, et réciproquement, la grille du transistor MP42 est connectée au drain du transistor MP41. De même, la grille du transistor MP43 est connectée au drain du transistor MP44, et réciproquement, la grille du transistor MP44 est connectée au drain du transistor MP42.

Le drain du transistor MP41 qui fournit un signal B3, est connecté au drain du transistor MN41 dont la grille reçoit le signal A3 et dont la source est connectée au drain du transistor MN45. Le drain du transistor MP42 est connecté au drain du transistor MN42 dont la grille reçoit le signal A4 et dont la source est connectée à la masse. De même, le drain du transistor MP43 est connecté au drain du transistor MN43 dont la grille reçoit le signal A4 et dont la source est connectée au drain du transistor MN46. Le drain du transistor MP44 qui fournit un signal C3, est connecté au drain du transistor MN44 dont la grille reçoit le signal A3 et dont la source est connectée à la masse.

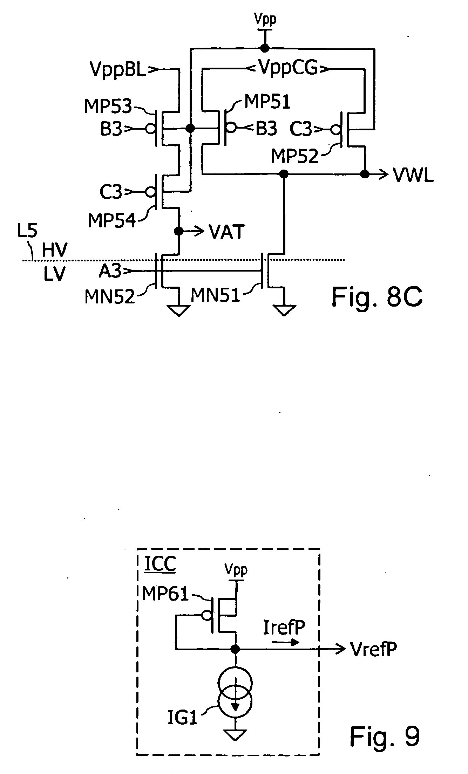

Sur la figure 8C, chaque verrou RLi comprend quatre transistors PMOS MP51, MP52, MP53, MP54 dont le substrat est à la tension Vpp, et deux transistors NMOS MN51, MN52. Les transistors MP51 et MP52 reçoivent sur leur source le signal VppCG et fournissent sur leur drain le signal VWL. Le transistor MP51 reçoit sur sa grille le signal B3, et le transistor MP52 reçoit sur sa grille le signal C4. Le transistor MN51 dont la source est à la masse, reçoit sur son drain le signal VWL et sur sa grille le signal A3. Le signal VppBL est appliqué à la source du transistor MP53 qui reçoit sur sa grille le signal B3. La source du transistor MP54 est connectée au drain du transistor MP53. Le transistor MP54 reçoit sur sa grille le signal C4 et fournit sur son drain le signal VAT. Le transistor MN52 sont la source est à la masse, reçoit sur son drain le signal VAT, et sur sa grille le signal A3.

Les figure 8B et 8C montrent également en pointillés une ligne L4, L5 de séparation entre des zones de circuit susceptibles d'être soumises à une haute tension HV de l'ordre de la tension Vpp, et des zones soumises à une tension plus basse LV, l'ensemble du circuit de la figure 8A n'étant pas soumis à la haute tension HV. Les lignes L4 et L5 font apparaître que les transistors MP41 à MP46, et MP51 à MP54, ainsi que les drains des transistors MN41 à MN44, MN51 et MN52 sont soumis à une tension de l'ordre de Vpp. Pour des raisons analogues à celles exposées ci-dessus en référence à la figure 6, seuls les transistors MP41 à MP44, MN41 à MN44, MN51 et MN52 sont exposés à un risque de claquage d'oxyde de grille.

Par ailleurs, le circuit de la figure 8B comprend deux circuits redondants de translation de niveau de tension fournissant respectivement les signaux B3 et C3 en entrée du circuit de la figure 8C. Ainsi, si l'un des deux circuits de translation de niveau de tension est défaillant en raison de la défaillance d'un des transistors MP41, MP42, MN41, MN42 du premier circuit, ou l'un des transistors MP43, MP44, MN43, MN44 du second circuit, l'un des signaux B3 ou C3 est toujours valide. Le circuit de la figure 8C assure la fonction d'une porte logique OU limitée en courant, recevant en entrée les signaux B3 et C3 et fournissant en sortie le signal VWL, ainsi que la fonction d'une porte logique ET limitée en courant, recevant en entrée les signaux B3 et C3 et fournissant en sortie le signal VAT.

Le verrou de ligne RLi d'une ligne non sélectionnée (verrou basse tension 15, I6 abaissé) fournit des signaux VWL et VAT à 0. Le verrou de ligne RLi d'une ligne sélectionnée fournit durant une phase d'effacement un signal VWL à la tension Vpp et un signal VAT à 0. Durant une phase d'écriture, le verrou de ligne RLi d'une ligne sélectionnée fournit un signal VWL à Vpp ou Vcc et un signal VAT à la tension Vpp.

En cas de défaillance d'un transistor haute tension, la consommation de courant sur les tensions Vpp, VppBL et VppCG reste limitée grâce aux transistors MP45 et MP46 qui sont polarisés pour assurer une fonction de limitation de courant. Typiquement, l'intensité des signaux circulant dans les transistors MP45 et MP46, et donc l'intensité des signaux B3 et C3 est limitée à une valeur de l'ordre de 1 µA.

Le verrou de ligne de mot RLi qui vient d'être décrit permet également de garantir qu'une commande d'effacement de cellules mémoire soit exécutée même si l'un des transistors haute tension du verrou a subi un claquage d'oxyde de grille. Le verrou de ligne de mot RLi ne peut pas non plus activer le signal VAT s'il n'est pas sélectionné, de sorte qu'une commande de programmation ou de lecture de cellules mémoire ne peut pas atteindre des cellules mémoire sélectionnées par erreur en raison d'un claquage d'oxyde de grille dans l'un des verrous RLi. A cet effet, le verrou RLi assure les conditions suivantes. Lorsque le signal VWL doit être abaissé, un claquage de transistor haute tension peut le laisser à l'état abaissé ou le faire passer par erreur à l'état levé. Lorsque le signal VAT doit être levé, un claquage de transistor haute tension peut le faire passer à l'état levé ou le laisser par erreur à l'état abaissé. Lorsque le signal VWL doit être levé, il ne doit pas rester par erreur à l'état abaissé. Lorsque le signal VAT doit être abaissé, il ne doit pas passer par erreur à l'état levé.

Or en cas de claquage d'un transistor haute tension, au moins l'un des signaux B3 et C3 reste valide grâce à la prévision des circuits de translation de niveau redondants (figure 8B). Il en résulte que l'un des signaux B3 ou C3 n'est plus valide, c'est-à-dire que l'un de ces signaux reste à la tension Vpp et l'autre se trouve dans un état indéterminé. Grâce aux fonctions logiques OU et ET réalisées par le circuit de la figure 8C, le signal VAT reste à 0 sachant qu'au moins l'un des deux transistors MP53 et MP54 est non passant. Pour une ligne sélectionnée, le signal VWL passe à la tension Vpp pendant une phase d'effacement, grâce aux transistors MP51 et MP52 en parallèle, sachant qu'au moins l'un de ces deux transistors et passant. Il en résulte que la défaillance d'un verrou de ligne RLi ne peut pas empêcher l'effacement de cellules mémoire, mais peut seulement empêcher la programmation d'une cellule mémoire du mot à programmer, ou provoquer l'effacement d'autres cellules mémoire situées dans la même ligne de mot que celles à effacer, mais dans une autre colonne.

Par ailleurs, le claquage de l'oxyde de grille d'un transistor de contrôle de grille CGTk n'a aucun effet en effacement ou en programmation d'une cellule de la même colonne COLk. En lecture, la tension et/ou l'intensité du signal VWL sont limitées, ce qui empêche la tension VCG de devenir excessive, et donc de lire un état programmé à la place d'un état effacé de cellule mémoire.

La figure 9 représente un exemple de réalisation du circuit de contrôle de courant ICC. Le circuit ICC comprend un transistor PMOS MP61 ayant sa source recevant la tension Vpp, et sa grille ramenée sur son drain. Le transistor MP61 est agencé en série avec un générateur de courant IG1 imposant un courant maximum dans le transistor MP61. Le courant IrefP à la tension VrefP est prélevé sur la source du transistor MP61. Il est préférable que le courant IrefP soit limité lors des opérations d'écriture à une valeur de l'ordre de 1 µA, voire à une valeur inférieure. Ainsi, le courant IrefP peut avoir une valeur de l'ordre de 100 nA. Toutefois, en dehors des opérations d'écriture, il est utile de ne pas limiter le courant IrefP à des valeurs aussi basses, pour ne par ralentir le fonctionnement des verrous LPkj, LTk et RLi, et donc de la mémoire. Ainsi, en dehors des opérations d'écriture, le courant IrefP pourrait être fixé à une valeur de l'ordre de 10 µA ou supérieure. En cas de claquage d'un transistor haute tension, le courant IrefP est fourni par la tension d'alimentation Vpp qui est égale à la tension d'alimentation Vcc en dehors des phases de programmation.

Grâce aux circuits décrits en référence aux figures 4 à 8, l'état par défaut, par exemple l'état effacé, est privilégié en cas de claquage d'un oxyde de grille de transistor, où qu'il se trouve, non seulement lors de la lecture d'une cellule mémoire, mais également lors de l'écriture (effacement, ou programmation) d'une cellule mémoire.

Il apparaîtra clairement à l'homme de l'art que la présente invention est susceptible de diverses variantes de réalisation et applications. En particulier, l'invention est applicable à diverses autres structures de mémoire EEPROM que celle décrite. Par exemple, l'invention est également applicable à une mémoire dans laquelle les bits d'un mot lu sont accédés séquentiellement, c'est-à-dire une mémoire ne comportant qu'un amplificateur de lecture.

Par ailleurs, d'autres circuits de lecture que ceux décrits peuvent être prévus pour déterminer la valeur d'un bit lu dans la mémoire en fonction de l'état des deux cellules mémoire correspondantes. En effet, pour déterminer la valeur d'un bit lu dans la mémoire, il n'est pas nécessaire qu'un état de cellule mémoire non défectueuse soit prépondérant sur l'état par défaut d'une cellule mémoire défectueuse. Le circuit de lecture peut par exemple déterminer si l'état de l'une des deux cellules mémoire correspondant au bit de donnée à lire est l'état par défaut, et fournir l'état de l'autre cellule mémoire en tant que valeur du bit de donnée à lire.

D'autres mesures peuvent également être prévues dans les verrous de ligne de mot, de ligne de bit et de colonne pour que l'état lu de cellules défectueuses soit dans un état par défaut.

## Revendications

1. Mémoire effaçable et programmable électriquement, comprenant des cellules mémoire (CEikj) agencées en lignes de bit (BLkj) et en lignes de mot (WLi) transversales aux lignes de bit, chaque cellule mémoire pouvant être dans un état programmé ou effacé,
**caractérisée en ce qu'**elle comprend des circuits de sélection et d'accès de cellules mémoire (RDEC, LTk, LPkj, ATLi) configurés pour mémoriser et lire un bit de donnée (bj) dans deux cellules mémoire (CExyj, CEvzj) appartenant à des lignes de bit distinctes (BLyj, BLzj) et des lignes de mot distinctes (WLx, WLv), et pour éviter qu'une cellule mémoire soit par erreur écrite ou lue dans un autre état qu'un état par défaut à la suite d'un claquage d'oxyde de grille d'un transistor de la mémoire, et un circuit de lecture (CLC) pour déterminer un bit de donnée (bj) à lire dans la mémoire en fonction des états des deux cellules mémoire mémorisant le bit de donnée (bj).

2. Mémoire selon la revendication 1, dans laquelle le circuit de lecture (CLC) est configuré pour que l'état d'une cellule mémoire (CEikj) non erronée soit, pour le circuit de lecture, prépondérant sur l'état par défaut de cellule mémoire erronée.

3. Mémoire selon la revendication 1 ou 2, dans laquelle les cellules mémoire (CEikj) sont regroupées en emplacements de mot qui peuvent chacun être sélectionnés par un décodeur de colonne de mot (CDEC) et un décodeur de ligne de mot (RDEC), un mot de donnée étant mémorisé dans la mémoire en deux emplacements de mot (Wxy, Wvz) appartenant à des lignes de mot distinctes (WLx, WLv) et des colonnes de mot distinctes (COLy, COLz).

4. Mémoire selon l'une des revendications 1 à 3, dans laquelle l'état par défaut de cellule mémoire (CEikj) erronée est l'état effacé, le circuit de lecture comprenant une porte logique OU (OGj) fournissant un bit de donnée (bj) mémorisé en mémoire, en fonction des états des deux cellules mémoire mémorisant le bit de donnée.

5. Mémoire selon l'une des revendications 1 à 4, dans laquelle l'état par défaut de cellule mémoire (CEikj) erronée est l'état effacé, chaque cellule mémoire (CEikj) comprenant un transistor à grille flottante (FGT) et un transistor d'accès (AT) connecté à une borne du transistor à grille flottante, la mémoire comprenant des circuits (LTk) pour générer une tension de lecture (Vread) de cellules mémoire (CEikj) choisie plus proche d'une tension de seuil (VTw) de transistor à grille flottante à l'état programmé qu'une tension de seuil (VTe) de transistor à grille flottante à l'état effacé, de manière à privilégier l'état effacé lors de la lecture d'une cellule mémoire.

6. Mémoire selon l'une des revendications 1 à 3, dans laquelle l'état par défaut est l'état programmé, le circuit de lecture comprenant une porte logique ET fournissant un bit (bj) mémorisé dans la mémoire en fonction des états des deux cellules mémoire mémorisant le bit de donnée.

7. Mémoire selon l'une des revendications 1 à 6, comprenant des verrous de ligne de bit (LPkj), des verrous de colonne (LTk) et des verrous de ligne de mot (RLi) pour commander l'effacement, la programmation et la lecture de cellules mémoire (CEikj), qui sont configurés pour qu'une cellule mémoire sélectionnée soit lue dans l'état par défaut en cas de claquage d'un oxyde de grille de transistor.

8. Mémoire selon l'une des revendications 1 à 7, dans laquelle chaque cellule mémoire comprend un transistor à grille flottante (FGT) et un transistor d'accès (AT) connecté à une borne du transistor à grille flottante, la mémoire comprenant un circuit de sélection de ligne de mot (RDEC) pour appliquer un premier signal (VAT) à la grille du transistor d'accès de cellules (CEikj) d'une ligne de mot sélectionnée (WLi), et un second signal (VWL) à la grille d'un transistor de contrôle de grille (CGTk) d'un mot (Wik) sélectionné, le second signal étant distinct du premier signal.

9. Mémoire selon l'une des revendications 1 à 8, comprenant des verrous de ligne de bit (LPkj), des verrous de colonne (LTk) et des verrous de ligne de mot (RLi) pour commander l'effacement, la programmation et la lecture de cellules mémoire (CEikj), les verrous de colonne et les verrous de ligne de mot comprenant des circuits redondants pour pouvoir générer des signaux d'effacement ou de programmation (VCG, VWL, VAT) permettant d'assurer l'effacement d'une cellule mémoire à effacer, et empêchant la programmation par erreur d'une cellule mémoire, en cas de claquage d'un oxyde de grille de transistor.

10. Procédé d'accès à un bit de donnée (bj) dans une mémoire effaçable et programmable électriquement (10), comprenant des cellules mémoire (CEikj) agencées en lignes de bit (BLkj) et en lignes de mot (WLi) transversales aux lignes de bit, chaque cellule mémoire pouvant être dans un état programmé ou effacé,
**caractérisé en ce qu'**il comprend des étapes de sélection de deux lignes de bit distinctes (BLyj, BLzj) et deux lignes de mot distinctes (WLx, WLv) pour sélectionner deux cellules mémoire (CExyj, CEvzj), la lecture du bit de donnée (bj) comprenant des étapes consistant à lire l'état des deux cellules mémoire sélectionnées, et déterminer la valeur du bit de donnée en fonction des états des deux cellules mémoire sélectionnées, l'accès à une cellule mémoire étant effectué en évitant qu'une cellule mémoire soit par erreur écrite ou lue dans un autre état qu'un état par défaut à la suite d'un claquage d'oxyde de grille d'un transistor de la mémoire.

11. Procédé selon la revendication 10, dans lequel, lors de la détermination de la valeur du bit de donnée (bj), l'état d'une cellule mémoire (CEikj) non erronée est prépondérant sur l'état par défaut de cellule mémoire erronée.

12. Procédé selon la revendication 10 ou 11, dans lequel les cellules mémoire (CEikj) sont regroupées en emplacements de mot qui peuvent chacun être sélectionnés par un décodeur de colonne de mot (CDEC) et un décodeur de ligne de mot (RDEC), le procédé comportant des étapes de sélection de deux colonnes de mot distinctes (COLy, COLz) et deux lignes de mot distinctes (WLx, WLv) pour accéder à deux emplacements de mot (Wxy, Wvz) distincts chacun mémorisant un même mot de donnée.

13. Procédé selon l'une des revendications 10 à 12, dans lequel l'état par défaut de cellule mémoire (CEikj) erronée est l'état effacé, la détermination de la valeur du bit de donnée (bj) étant effectuée en appliquant une fonction logique OU aux états des deux cellules mémoire sélectionnées (CExyj, CEvzj).

14. Procédé selon l'une des revendications 10 à 13, dans lequel l'état par défaut de cellule mémoire (CEikj) erronée est l'état effacé, chaque cellule mémoire (CEikj) comprenant un transistor à grille flottante (FGT) et un transistor d'accès (AT) connecté à une borne du transistor à grille flottante, le procédé comprenant des étapes de génération d'une tension de lecture (Vread) de cellules mémoire (CEikj) choisie plus proche d'une tension de seuil (VTw) du transistor à grille flottante à l'état programmé qu'une tension de seuil (VTe) du transistor à grille flottante à l'état effacé, de manière à privilégier l'état effacé lors de la lecture d'une cellule mémoire.

15. Procédé selon l'une des revendications 10 à 12, dans lequel l'état par défaut est l'état programmé, la détermination de la valeur du bit de donnée (bj) étant effectuée en appliquant une fonction logique ET aux états des deux cellules mémoire sélectionnées (CExyj, CEvzj).

16. Procédé selon l'une des revendications 10 à 15, dans lequel chaque cellule mémoire comprend un transistor à grille flottante (FGT) et un transistor d'accès (AT) connecté à une borne du transistor à grille flottante, le procédé comprenant des étapes d'application d'un premier signal (VAT) à la grille du transistor d'accès de cellules (CEikj) d'une ligne de mot sélectionnée (WLi), et d'application d'un second signal (VWL) à la grille d'un transistor de contrôle de grille (CGTk) d'un mot (Wik) sélectionné, le second signal étant distinct du premier signal.

## Claims

1. Electrically erasable and programmable memory, comprising memory cells (CEikj) arranged in bit lines (BLkj) and word lines transverse to bit lines, wherein each memory cell may be in a programmed or erased state,
comprising circuits for selecting and accessing memory cells (RDEC, LTk, LPkj, ATLi) configured to memorize and read a data bit (bj) in two memory cells (CExyj, CEvzj) belonging to different bit lines (BLyj, BLzj) and different word lines (WLx, WLv), and to avoid a memory cell from being written or read by mistake in another state than a default state after a gate oxide breakdown of a transistor of the memory, and a read circuit (CLC) to determine a data bit (bj) to be read in the memory according to the states of the two memory cells memorizing the data bit (bj).

2. Memory according to claim 1, wherein the read circuit (CLC) is configured so that the state of a not erroneous memory cell (CEikj) is, for the read circuit, predominant over the default state of erroneous memory cell.

3. Memory according to claim 1 or 2, wherein the memory cells (CEikj) are gathered into word locations, each word location may be selected by a word column decoder (CDEC) and a word line decoder (RDEC), a word of data being memorized in the memory in two word locations(Wxy, Wvz) belonging to different word lines (WLx, WLv) and different word columns (COLy, COLz).

4. Memory according to one of claims 1 to 3, wherein the default state of erroneous memory cell (CEikj) is the erased state, the read circuit comprising an OR logic gate (OGj) supplying a data bit (bj) memorized in memory, according to the states of the two memory cells memorizing the data bit.

5. Memory according to one of claims 1 to 4, wherein the default state of erroneous memory cell (CEikj) is the erased state, each memory cell (CEikj) comprising a floating gate transistor (FGT) and an access transistor (AT) connected to a terminal of the floating gate transistor, the memory comprising circuits (LTk) to generate a read voltage (Vread) for reading memory cells (CEikj) chosen nearer a threshold voltage (VTw) of floating gate transistor in the programmed state than a threshold voltage (VTe) of floating gate transistor in the erased state, in order to favor the erased state when reading a memory cell.

6. Memory according to one of claims 1 to 3, wherein the default state is the programmed state, the read circuit comprising an AND logic gate supplying a bit memorized in the memory according to the states of the two memory cells memorizing the data bit.

7. Memory according to one of claims 1 to 6, comprising bit line latches (LPkj), column latches (LTk) and word line latches (RLi) to control erasing, programming and reading memory cells (CEikj), which are configured so that a selected memory cell is read in the default state in the event of a transistor gate oxide breakdown.

8. Memory according to one of claims 1 to 7, wherein each memory cell comprises a floating gate transistor (FGT) and an access transistor (AT) connected to a terminal of the floating gate transistor, the memory comprising a word line selection circuit (RDEC) to apply a first signal (VAT) to the gate of the access transistor of cells (CEikj) of a selected word line (WLi), and a second signal (VWL) to the gate of a gate control transistor (CGTk) of a selected word (Wik), the second signal being different from the first signal.

9. Memory according to one of claims 1 to 8, comprising bit line latches (LPkj), column latches (LTk) and word line latches (RLi) to control erasing, programming and reading memory cells (CEikj), the column latches and word line latches comprising redundant circuits to be able to generate erase or program signals (VCG, VWL, VAT) making it possible to perform erasing a memory cell to be erased, and preventing a memory cell from being programmed by mistake, in the event of a transistor gate oxide breakdown.

10. Method for accessing a data bit (bj) in an electrically erasable and programmable memory (10), comprising memory cells (CEikj) arranged in bit lines (BLkj) and word lines (WLi) transverse to bit lines, wherein each memory cell may be in a programmed or erased state,
comprising selecting two different bit lines (BLyj, BLzj) and two different word lines (WLx, WLv) to select two memory cells (CExyj, CEvzj), reading the data bit (bj) comprising reading the states of the two selected memory cells, and determining the value of the data bit according to the states of the two selected memory cells, accessing a memory cell being performed avoiding a memory cell from being written or read by mistake in another state than a default state after a gate oxide breakdown of a transistor of the memory.

11. Method according to claim 10, wherein, during the determination of the value of the data bit (bj), the state of a not erroneous memory cell (CEikj) is predominant over the default state of erroneous memory cell.

12. Method according to claim 10 or 11, wherein the memory cells (CEikj) are gathered into word locations, each may be selected by a word column decoder (CDEC) and a word line decoder (RDEC), the method comprising selecting two different word columns (COLy, COLz) and two different word lines (WLx, WLv) to access two different word locations (Wxy, Wvz), each memorizing a same data word.

13. Method according to one of claims 10 to 12, wherein the default state of erroneous memory cell (CEikj) is the erased state, the determination of the value of the data bit (bj) being performed by applying an OR logic function to the states of the two selected memory cells (CExyj, CEvzj).

14. Method according to one of claims 10 to 13, wherein the default state of erroneous memory cell (CEikj) is the erased state, each memory cell (CEikj) comprising a floating gate transistor (FGT) and an access transistor (AT) connected to a terminal of the floating gate transistor, the method comprising generating a read voltage (Vread) for reading memory cells (CEikj) chosen nearer a threshold voltage (VTw) of the floating gate transistor in the programmed state than a threshold voltage (VTe) of the floating gate transistor in the erased state, in order to favor the erased state when reading a memory cell.

15. Method according to one of claims 10 to 12, wherein the default state is the programmed state, the determination of the value of the data bit (bj) being performed by applying an AND logic function to the states of the two selected memory cells(CExyj, CEvzj).

16. Method according to one of claims 10 to 15, wherein each memory cell comprises a floating gate transistor (FGT) and an access transistor (AT) connected to a terminal of the floating gate transistor, the method comprising applying a first signal (VAT) to the gate of the access transistor of cells (CEikj) of a selected word line(WLi), and applying a second signal (VWL) to the gate of a gate control transistor (CGTk) of a selected word (Wik), the second signal being different from the first signal.

## Patentansprüche

1. Elektrisch löschbarer und programmierbarer Speicher, umfassend zu Bitleitungen (BLkj) und zu quer zu den Bitleitungen liegenden Wortleitungen (WLi) angeordnete Speicherzellen (CEikj), wobei jede Speicherzelle in einem programmierten oder gelöschten Zustand sein kann,
**dadurch gekennzeichnet, dass** er Speicherzellen-Auswahl- und Zugriffsschaltungen (RDEC, LTk, LPkj, ATLi) umfasst, die so konfiguriert sind, dass sie ein Datenbit (bj) in zwei zu unterschiedlichen Bitleitungen (BLyj, BLzj) und unterschiedlichen Wortleitungen (WLx, WLv) gehörenden Speicherzellen (CExyj, CEvzj) speichern und lesen, und dass vermieden wird, dass infolge eines Gateoxid-Durchbruchs eines Transistors des Speichers eine Speicherzelle in einem anderen Zustand als ein Default-Zustand irrtümlich geschrieben oder gelesen wird, und eine Leseschaltung (CLC) zur Bestimmung eines Datenbits (bj), das im Speicher abhängig von den Zuständen der beiden das Datenbit (bj) speichernden Speicherzellen zu lesen ist.

2. Speicher nach Anspruch 1, in dem die Leseschaltung (CLC) so konfiguriert ist, dass der Zustand einer nicht fehlerhaften Speicherzelle (CEikj) vorrangig über den Default-Zustand einer fehlerhaften Speicherzelle für die Leseschaltung ist.

3. Speicher nach Anspruch 1 oder 2, in dem die Speicherzellen (CEikj) zu Wortstellen zusammengefasst sind, von denen jede durch einen Wortspaltendecoder (CDEC) und einen Wortleitungsdecoder (RDEC) ausgewählt werden kann, wobei ein Datenwort im Speicher in zwei zu unterschiedlichen Wortleitungen (WLx, WLv) und unterschiedlichen Wortspalten (COLy, COLz) gehörenden Wortstellen (Wxy, Wvz) gespeichert wird.

4. Speicher nach einem der Ansprüche 1 bis 3, in dem der Default-Zustand einer fehlerhaften Speicherzelle (CEikj) der gelöschte Zustand ist, wobei die Leseschaltung eine ODER-Torschaltung (OGj) umfasst, die ein im Speicher gespeichertes Datenbit (bj) abhängig von den Zuständen der beiden das Datenbit speichernden Speicherzellen liefert.

5. Speicher nach einem der Ansprüche 1 bis 4, in dem der Default-Zustand einer fehlerhaften Speicherzelle (CEikj) der gelöschte Zustand ist, wobei jede Speicherzelle (CEikj) einen Floating-Gate-Transistor (FGT) und einen mit einem Anschluss des Floating-Gate-Transistors verbundenen Zugriffstransistor (AT) umfasst, der Speicher umfassend Schaltungen (LTk) zum Generieren einer Lesespannung (Vread) zum Lesen von Speicherzellen (CEikj), welche näher an einer Schwellenspannung (VTw) eines Floating-Gate-Transistors im programmierten Zustand als an einer Schwellenspannung (VTe) eines Floating-Gate-Transistors im gelöschten Zustand so ausgewählt ist, dass der gelöschte Zustand beim Lesen einer Speicherzelle privilegiert wird.

6. Speicher nach einem der Ansprüche 1 bis 3, in dem der Default-Zustand der programmierte Zustand ist, die Leseschaltung umfassend eine UND-Torschaltung, die ein im Speicher gespeichertes Bit (bj) abhängig von den Zuständen der beiden das Datenbit speichernden Speicherzellen liefert.

7. Speicher nach einem der Ansprüche 1 bis 6, umfassend Bitleitungsriegel (LPkj), Spaltenriegel (LTk) und Wortleitungsriegel (RLi), um das Löschen, das Programmieren und das Lesen von Speicherzellen (CEikj) zu steuern, die so konfiguriert sind, dass beim Durchbruch eines Transistor-Gateoxids eine ausgewählte Speicherzelle im Default-Zustand gelesen wird.

8. Speicher nach einem der Ansprüche 1 bis 7, in dem jede Speicherzelle einen Floating-Gate-Transistor (FGT) und einen mit einem Anschluss des Floating-Gate-Transistors verbundenen Zugriffstransistor (AT) umfasst, der Speicher umfassend eine Wortleitungsauswahlschaltung (RDEC) zur Anwendung eines ersten Signals (VAT) auf das Gate des Zugriffstransistors von Zellen (CEikj) einer ausgewählten Wortleitung (WLi), und eines zweiten Signals (VWL) auf das Gate eines Gate-Steuer-Transistors (CGTk) eines ausgewählten Wortes (Wik), wobei das zweite Signal unterschiedlich von dem ersten Signal ist.

9. Speicher nach einem der Ansprüche 1 bis 8, umfassend Bitleitungsriegel (LPkj), Spaltenriegel (LTk) und Wortleitungsriegel (RLi), um das Löschen, das Programmieren und das Lesen von Speicherzellen (CEikj) zu steuern, wobei die Spaltenriegel und die Wortleitungsriegel redundante Schaltungen umfassen, um Signale zum Löschen oder Programmieren (VCG, VWL, VAT) generieren zu können, wodurch eine zu löschende Speicherzelle gelöscht werden kann, und das irrtümliche Programmieren einer Speicherzelle beim Durchbruch eines Transistor-Gateoxids verhindert wird.

10. Verfahren zum Zugriff zu einem Datenbit (bj) in einem elektrisch löschbaren und programmierbaren Speicher (10), umfassend zu Bitleitungen (BLkj) und zu quer zu den Bitleitungen liegenden Wortleitungen (WLi) angeordnete Speicherzellen (CEikj), wobei jede Speicherzelle in einem programmierten oder gelöschten Zustand sein kann,
**dadurch gekennzeichnet, dass** es Schritte zur Auswahl von zwei unterschiedlichen Bitleitungen (BLyj, BLzj) und zwei unterschiedlichen Wortleitungen (WLx, WLv) umfasst, um zwei Speicherzellen (CExyj, CEvzj) auszuwählen, wobei das Lesen des Datenbits (bj) Schritte umfasst, die darin bestehen, den Zustand der beiden ausgewählten Speicherzellen zu lesen, und abhängig von den Zuständen der beiden ausgewählten Speicherzellen den Wert des Datenbits zu bestimmen, wobei der Zugriff auf eine Speicherzelle so stattfindet, dass vermieden wird, dass eine Speicherzelle infolge eines Gateoxid-Durchbruchs eines Transistors des Speichers in einem anderen Zustand als ein Default-Zustand irrtümlich geschrieben oder gelesen wird.

11. Verfahren nach Anspruch 10, in dem der Zustand einer nicht fehlerhaften Speicherzelle (CEikj) vorrangig über den Default-Zustand einer fehlerhaften Speicherzelle bei der Bestimmung des Wertes des Datenbits (bj) ist.

12. Verfahren nach Anspruch 10 oder 11, in dem die Speicherzellen (CEikj) zu Wortstellen zusammengefasst werden, von denen jede durch einen Wortspaltendecoder (CDEC) und einen Wortleitungsdecoder (RDEC) ausgewählt werden kann, das Verfahren umfassend Schritte zur Auswahl von zwei unterschiedlichen Wortspalten (COLy, COLz) und zwei unterschiedlichen Wortleitungen (WLx, WLv), um auf zwei unterschiedliche Wortstellen (Wxy, Wvz) Zugriff zu haben, von denen jede ein selbes Datenwort speichert.

13. Verfahren nach einem der Ansprüche 10 bis 12, in dem der Default-Zustand einer fehlerhaften Speicherzelle (CEikj) der gelöschte Zustand ist, wobei der Wert des Datenbits (bj) bestimmt wird, indem eine logische ODER-Funktion auf die Zustände der beiden ausgewählten Speicherzellen (CExyj, CEvzj) angewendet wird.

14. Verfahren nach einem der Ansprüche 10 bis 13, in dem der Default-Zustand einer fehlerhaften Speicherzelle (CEikj) der gelöschte Zustand ist, jede Speicherzelle (CEikj) umfassend einen Floating-Gate-Transistor (FGT) und einen mit einem Anschluss des Floating-Gate-Transistors verbundenen Zugriffstransistor (AT), das Verfahren umfassend Schritte zur Erzeugung einer Lesespannung (Vread) zum Lesen von Speicherzellen (CEikj), welche näher an einer Schwellenspannung (VTw) des Floating-Gate-Transistors im programmierten Zustand als an einer Schwellenspannung (VTe) des Floating-Gate-Transistors im gelöschten Zustand so ausgewählt ist, dass der gelöschte Zustand beim Lesen einer Speicherzelle privilegiert wird.

15. Verfahren nach einem der Ansprüche 10 bis 12, in dem der Default-Zustand der programmierte Zustand ist, wobei der Wert des Datenbits (bj) bestimmt wird, indem eine logische UND-Funktion auf die Zustände der beiden ausgewählten Speicherzellen (CExyj, CEvzj) angewendet wird.

16. Verfahren nach einem der Ansprüche 10 bis 15, in dem jede Speicherzelle einen Floating-Gate-Transistor (FGT) und einen mit einem Anschluss des Floating-Gate-Transistors verbundenen Zugriffstransistor (AT) umfasst, das Verfahren umfassend Schritte zur Anwendung eines ersten Signals (VAT) auf das Gate des Zugriffstransistors von Zellen (CEikj) einer ausgewählten Wortleitung (WLi), und zur Anwendung eines zweiten Signals (VWL) auf das Gate eines Gate-Steuer-Transistors (CGTk) eines ausgewählten Wortes (Wik), wobei das zweite Signal unterschiedlich von dem ersten Signal ist.
